# EUROPÄISCHE PATENTSCHRIFT

(11) **EP 1 968 173 B1**
(45) Veröffentlichungstag und Bekanntmachung des Hinweises auf die Patenterteilung: **24.02.2010**
(21) Anmeldenummer: 08000077.1
(22) Anmeldetag: 04.01.2008
(51) Int. Cl.: H02K 29/06, H02K 29/08, H02K 11/00

(54) **Elektronisch kommutierter Außenläufermotor mit einer Leiterplatte**
Electronically commutatable external rotor motor with a conductor board
Moteur à rotor extérieur commuté électroniquement et doté d'une plaquette

(30) Priorität: 06.03.2007 DE 202007003812 U
(43) Veröffentlichungstag der Anmeldung: 10.09.2008
(73) Patentinhaber: ebm-papst St. Georgen GmbH & Co. KG, 78112 St. Georgen (DE)
(72) Erfinder: Fischer, Klaus S., 78739 Hardt (DE); Cosco, Pino, 78112 St. Georgen (DE)
(74) Vertreter: Raible, Tobias

(56) Entgegenhaltungen:
- EP-A- 0 558 181
- DE-A1- 3 519 824

## Beschreibung

Die Erfindung betrifft einen elektronisch kommutierten Außenläufermotor mit einer Leiterplatte.

Bei derartigen Motoren wird eine Leiterplatte zur Aufnahme von elektronischen Bauelementen für die Motorsteuerung verwendet. In diese Leiterplatte wird ein sogenannntes Fenster vorgesehen, also ein Loch, in dem ein Hallsensor zur Erzeugung von Rotorstellungssignalen angeordnet ist. Dies ermöglicht eine kompakte Bauweise des Motors, weil für den Hallsensor kein zusätzlicher Platz benötigt wird.

Bei derartigen Leiterplatten tritt das Problem auf, dass im Betrieb ESD-Entladungen (ESD = electrostatic discharge) entstehen können, welche Schäden am Motor verursachen.

Die DE 3 519 824 A1 betrifft einen Außenläufer-Antriebsmotor für einen Festplattenspeicher. Die Welle dieses Motors ist in einem Lagerrohr in zwei Kugellagern gelagert. Gegen das freie Ende dieser Welle liegt ein elektrisch leitendes Axiallager an, das auf einem elektrisch leitenden Federbügel sitzt. Auf diese Weise werden elektrostatische Auf ladungen der Welle abgeleitet. Diese Methode hilft aber dort nicht, wo Teile des Rotors aus Kunststoff hergestellt, also nichtleitend sind.

Es ist deshalb eine Aufgabe der Erfindung, einen neuen elektronisch kommutierten Außenläufermotor bereit zu stellen.

Nach der Erfindung wird diese Aufgabe gelöst durch einen Motor gemäß Anspruch 1 und eine Leiterplatte gemäß Anspruch 7. Bevorzugte Ausführungsformen sind Gegenstand der Unteransprüche.

Auf diese Weise können ESD-Entladungen durch eine hierfür vorgesehene Ausnehmung der Leiterplatte erfolgen, so dass der Motor auf einfache Weise davor geschützt wird, durch eine solche Entladung beschädigt oder zerstört zu werden.

Weitere Einzelheiten und vorteilhafte Weiterbildungen der Erfindung ergeben sich aus dem im folgenden beschriebenen und in den Zeichnungen dargestellten, in keiner Weise als Einschränkung der Erfindung zu verstehenden Ausführungsbeispiel, sowie aus den Unteransprüchen. Es zeigt:
- Fig. 1: einen Längsschnitt durch ein Ausführungsbeispiel eines elektronisch kommutierten Außenläufermotors,
- Fig. 2: eine Draufsicht auf die Unterseite einer beim Motor der Fig. 1 verwendeten Leiterplatte, welche beim fertigen Motor mit elektronischen Bauelementen bestückt ist,
- Fig. 3: eine Seitenansicht eines Ausschnitts der Leiterplatte von Fig. 1 und 2, in stark vergrößerter Darstellung,
- Fig. 4: einen schematischen Längsschnitt durch den Motor, bei dem der Stator nicht dargestellt ist,
- Fig. 5: einen Schnitt, gesehen längs der Linie V-V der Fig. 4, und
- Fig. 6: eine schematische Darstellung, welche einen direkten Überschlag 110 vom Rückschlussteil 24 zu einem mit Masse 112 verbundenen Abschnitt 95', 95" zeigt.

In der nachfolgenden Beschreibung beziehen sich die Begriffe links, rechts, oben und unten auf die jeweilige Zeichnungsfigur und können in Abhängigkeit von einer jeweils gewählten Ausrichtung (Hochformat oder Querformat) von einer Zeichnungsfigur zur nächsten variieren. Gleiche oder gleich wirkende Teile werden in den verschiedenen Figuren mit denselben Bezugszeichen bezeichnet und gewöhnlich nur einmal beschrieben.

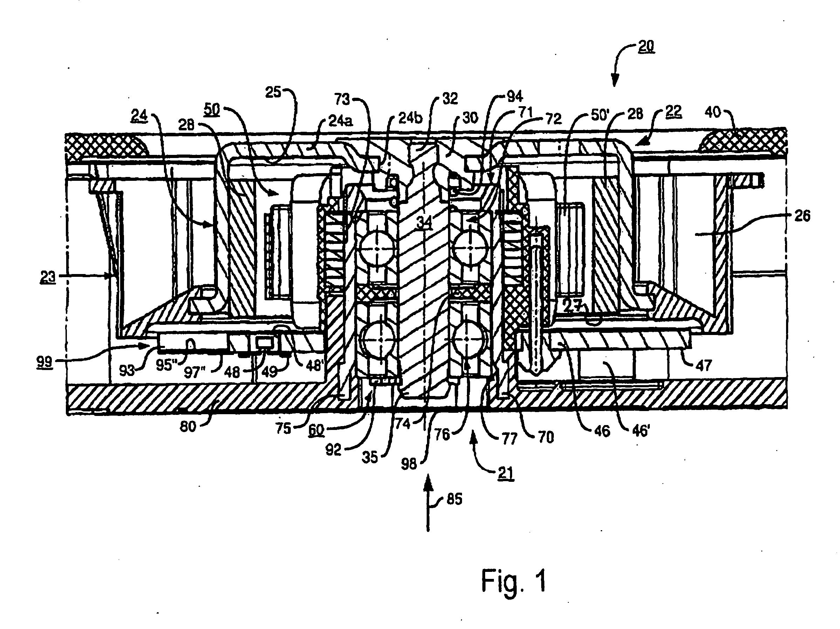

Fig. 1 zeigt einen Längsschnitt durch einen Lüfter 20 mit einem elektronisch kommutierten Außenläufermotor 21 und einer Leiterplatte 46 gemäß einer Ausführungsform der Erfindung. Der Lüfter 20 ist beispielhaft als Radiallüfter in stark vergrößertem Maßstab dargestellt. Alternativ könnte es z.B. ein Axiallüfter oder ein Diagnonallüfter sein. Bei einer praktischen Ausführung des Lüfters, wie er in Fig. 1 gezeigt ist, beträgt die Höhe etwa 15 mm und die Breite etwa 51 mm, d.h. Fig. 1 stellt diesen Lüfter in etwa 4,5-facher Vergrößerung dar. Andere Lüftertypen in anderen Größen können naturgemäß ebenfalls mit entsprechend modifizierten Leiterplatten versehen werden.

Der Motor 21 hat einen Außenrotor 22, einen Innenstator 50 mit einem Statorblechpaket 50', sowie ein an einem Kunststoffteil 80 befestigtes Lagerrohr 70. Durch das Kunststoffteil ist bei dieser Bauart das Lagerrohr 70 isoliert, ebenso ein in ihm gelagerter Außenrotor 22. Letzterer ist durch einen Luftspalt vom Innenstator 50 getrennt und hat eine als becherförmiges Trägerelement ausgebildete Rotorglocke 24 aus magnetisch leitendem Metall, z.B. aus tiefgezogenem Weicheisen. Die Glocke 24 hat an ihrem Außenumfang ein Lüfterrad 23 mit Lüfterflügeln 26. Am inneren Umfang der Glocke 24 ist ein radial magnetisierter Rotormagnet 28 befestigt, der z.B. vierpolig, sechspolig etc. magnetisiert sein kann. Dieser hat unterhalb seiner unteren Stirnseite 27 einen Streuflussbereich. Die Rotorglocke 24 hat einen Boden 24a mit einer zentralen Ausnehmung 24b, welche mittels einer Nabe 30 (aus einer Druckgusslegierung, z.B. Zamak oder dgl.), mit dem oberen Ende 32 einer Rotorwelle 34 verbunden ist, die ein unteres Wellende 35 hat und zur Lagerung im Lagerrohr 70 dient.

Im Lagerrohr 70 befindet sich eine Lageranordnung 60, die bei diesem Beispiel oben ein erstes Wälzlager 72 und unten ein zweites Wälzlager 76 hat, welche im vorgegebenen Abstand voneinander angeordnet sind. Dieser Abstand wird durch ein Distanzglied 74 definiert, z.B., wie dargestellt, eine Ringscheibe. Die Lageranordnung 60 ist nicht auf einen bestimmten Lagertyp beschränkt, vielmehr können z.B. auch Gleitlager oder eine magnetische Lagerung verwendet werden.

Das in Fig. 1 obere Ende 71 des Lagerrohrs 70 ist der Innenseite 25 der Rotorglocke 24 zugewandt und auf seiner inneren Seite mit einem Anschlag 73 versehen, gegen den der Außenring 72" des Wälzlagers 72 anliegt. Sein unteres Ende 75 ist innen mit einer Erweiterung 78 versehen, um ein Einführen der Lager 72, 76 in das Lagerrohr 70 zu erleichtern.

Das untere Ende 75 des Lagerrohrs 70 ist durch Kunststoffspritzen derart am Kunststoffteil 80 befestigt, dass der an das Lagerrohr angespritzte Kunststoff einen Anschlag 77 bildet, gegen den der Außenring 76" des unteren Lagers 76 anliegt. Das untere Ende 75 wird durch ein Klebeschild 98 aus Metall, oder durch eine sonstige geeignete Abdeckung, abgedeckt.

Die Welle 34 wird durch einen in eine Ringnut eingerasteten Sprengring 92 und eine Druckfeder 94 gehalten, welche zwischen dem Innenring 72' des Lagers 72 und der Nabe 30 angeordnet ist. Durch die Druckfeder 94 wird der Sprengring 92 gegen das zweite Wälzlager 76 gedrückt, so dass die Lager 72, 76 gegeneinander verspannt sind.

Der Innenstator 50 des Motors 21 ist auf der Außenseite des Lagerrohrs 70 befestigt. Dort ist auch eine Leiterplatte 46 angeordnet, welche eine vom Rotor 22 abgewandte Seite 47 hat, auf der sich eine gedruckte Schaltung mit elektronischen Bauelementen für diese gedruckte Schaltung befindet, z. B. ein IC 46'. Die dem Innenstator 50 zugewandte Seite der Leiterplatte 46 ist mit 29 bezeichnet und gewöhnlich nicht bestückt. Die Leiterplatte 46 liegt im Bereich zwischen dem Rotormagneten 28 und dem Statorblechpaket 50' einerseits und dem Flansch 80. Sie hat eine im folgenden als Hallfenster bezeichnete Durchbrechung 48', in der ein flacher galvanomagnetischer Sensor 48 angeordnet ist, welcher im Betrieb, gesteuert von der Drehstellung des Rotormagneten 22 relativ zum Innenstator 50, Rotorstellungssignale erzeugt. Auf seiner Oberseite, welche dem Rotormagneten zugewandt ist, ragt der Sensor 48 nicht oder nur ganz wenig über die Oberseite 29 der Leiterplatte 46 hinaus, so dass zwischen ihm und dem Ende 27 des Rotormagneten 22 nur ein sehr kleiner Luftspalt vorhanden ist.

Der Sensor 48 ist mittels Kontaktfüßen 49 verbunden mit Leiterbahnen 48H, die sich auf der unteren Seite 47 der Leiterplatte 46 befinden. Das Hallfenster 48' wird in einem Bereich der Leiterplatte 46 angeordnet, welcher sich mindestens teilweise im Streuflussbereich der Stirnseite 27 befindet.

In Fig. 1 ist nur ein Teil des Hallfensters 48' unter der Stirnseite 27 des Rotormagneten 28 angeordnet. An dieser Stelle ist das Magnetfeld des Rotormagneten 28 stark genug, um eine zuverlässige Erzeugung von Rotorstellungssignalen durch den Hallsensor 48 zu ermöglichen. Gleichzeitig ist dieser dann ausreichend weit von der Rotorglocke 24 entfernt, um einen sicheren Betrieb zu ermöglichen, wie das nachfolgend bei der Beschreibung der Wirkungsweise erläutert wird.

Zur Sicherung des Motors 21 gegen elektrostatische Entladungen hat dieser eine Ableitungsanordnung 99 zum Ableiten unerwünschter Ladungen aus dem Motor. Zu dieser gehört eine Durchbrechung 43 in der Leiterplatte 46. Diese Durchbrechung kann beispielsweise dadurch hergestellt werden, dass, ausgehend von der Außenseite der Leiterplatte 46, eine Nut in die Leiterplatte 46 gefräst wird. Am Rande dieser Nut 43 ist auf der Seite 47 der Leiterplatte 46 mindestens ein mit einem niedrigen Potential (gewöhnlich mit Masse) verbundener elektrischer Leiter 48H vorgesehen, welcher in Fig 1 beispielhaft als metallische Beschichtung 95', 95" dargestellt ist. Diese metallische Beschichtung ist bei dieser Ausführungsform durch Leiter 97', 97" mit dem niedrigen Potential verbunden. Naturgemäß sind hier viele Varianten möglich.

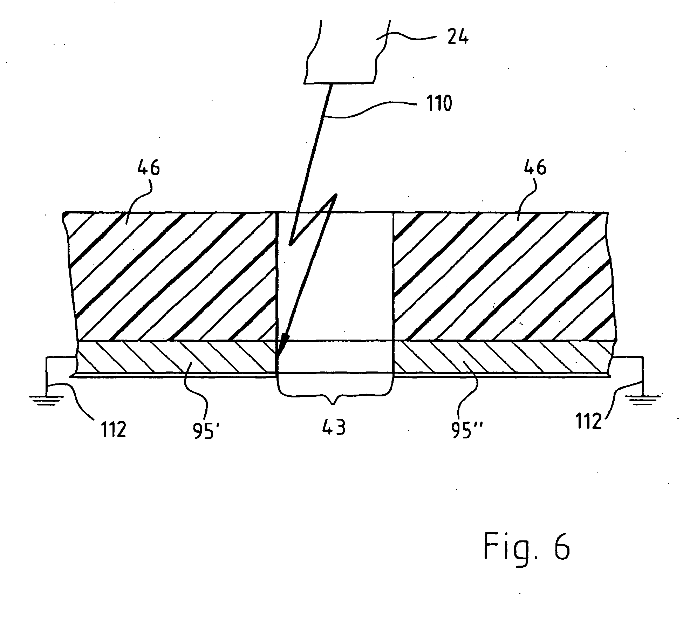

Die Anordnung 99 ist so ausgebildet, dass beim Auftreten von ESD-Entladungen, die z.B. eine Spannung von einigen kV haben können, ein bevorzugter Überschlag 110 (Fig. 6) von der Rotorglocke 24 zur metallischen Beschichtung 95', 95" beiderseits der Durchbrechung 43 ermöglicht wird, so dass ein solcher Überschlag keine Schäden an der Leiterplatte 46 und ihren Bauelementen verursachen kann.

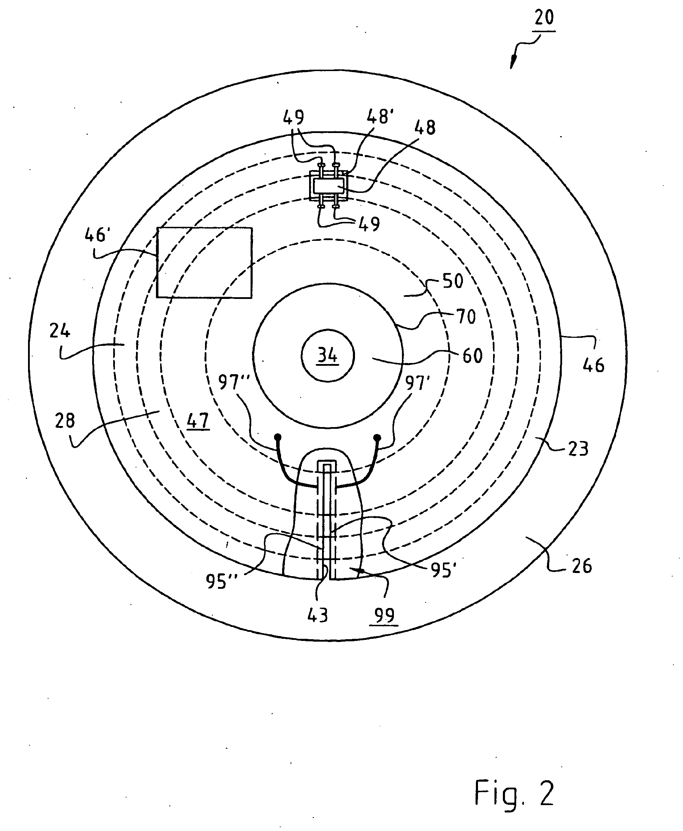

Fig. 2 zeigt eine Draufsicht auf die bestückte Seite 47 der Leiterplatte 46, auf der sich die elektronischen Bauelemente befinden, sowie den elektrischen Anschluss des Sensors 48 mittels seiner Kontaktfüße 49, sowie eine mögliche Ausgestaltung der Anordnung 99. Diese hat an jedem Rand der Nut 43 einen flächigen Leiter 95', 95", der über eine zugeordnete Leitung 97', 97" mit Masse oder einem sonstigen Potential verbunden ist. Als Leiter 95', 95" werden bevorzugt metallische Beschichtungen, meist aus Kupfer, verwendet.

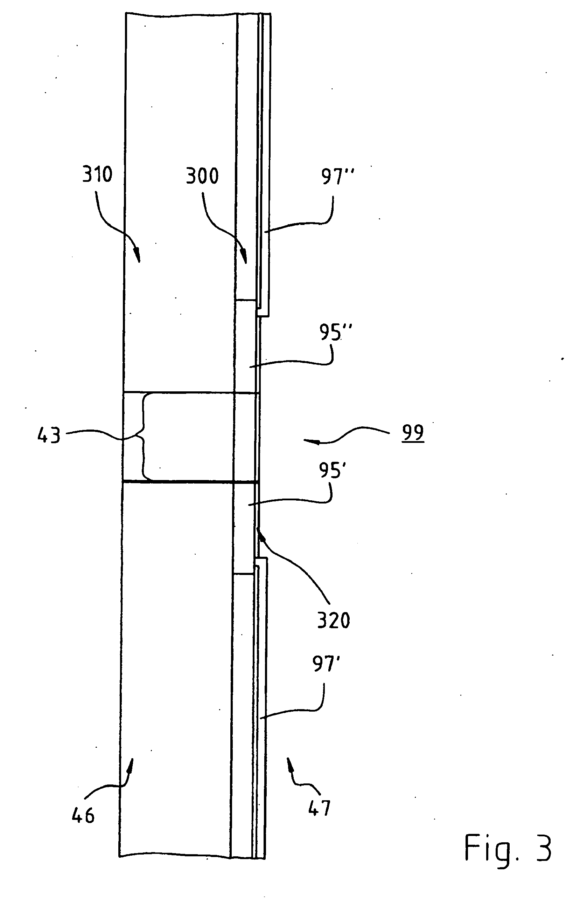

Fig. 3 zeigt zur Verdeutlichung der Anordnung 99 gemäß Fig. 1 und 2 eine stark vergrößerte Seitenansicht der Leiterplatte 46. Mit 310 ist die isolierende Leiterplatte bezeichnet. Auf dieser befinden sich eine Kupferschicht 300 sowie eine Lötstoppschicht 320.

Wie Fig. 3 zeigt, können die Leiter 95', 95" durch Entfernen der Lötstoppschicht 320 schnell hergestellt werden, da hierdurch in diesen Bereichen die Metallschicht 300 freigelegt wird. Alternativ können zusätzliche elektrische Leiter in diesen Bereichen angeordnet werden, z.B. durch Auflöten.

### Wirkungsweise

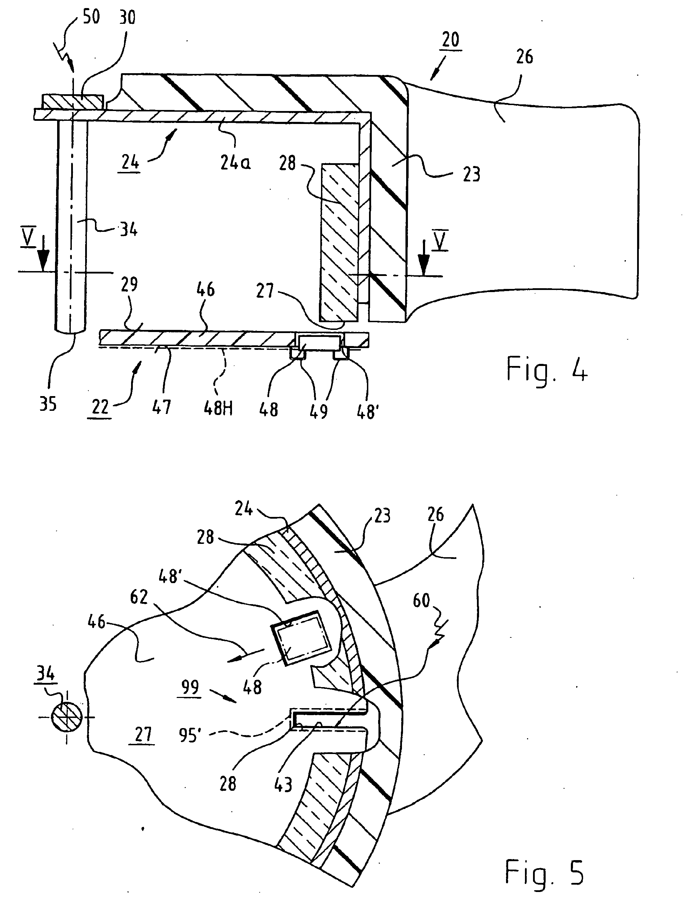

**Fig. 4 bis 6** zeigen stark schematisierte Darstellungen zur Erläuterung der Wirkungsweise. In Fig. 4 ist, mit Ausnahme der Leiterplatte 46, der Stator nicht dargestellt, um die Darstellung zu vereinfachen. Fig. 4 zeigt, wie der Rotor 22 eines Lüfters 20 einer ESD-Entladung 50 ausgesetzt wird, die an der Nabe 30 einschlägt. Da der Rotor 22 elektrisch isoliert ist, kann die elektrische Ladung nicht über die Welle 34 nach Masse abfließen, und folglich lädt sich der metallische Topf 24 des Lüfterrads auf.

Da die unbestückte Seite 29 der Leiterplatte 46 nach oben zeigt, würde die Leiterplatte 46 an sich als Isolator wirken und einen Überschlag verhindern. Jedoch befindet sich in der Leiterplatte 46 das Hallfenster 48', in welchem sich der Hallsensor 48 befindet. Wie Fig. 1 zeigt, hat der Hallsensor 48 Anschlusselemente 49, die in der üblichen Weise an Leiterbahnen auf der Unterseite 47 der Leiterplatte 46 angelötet sind. Das Hallfenster 48' und diese Anschlusselemente 49 ermöglichen dann einen Überschlag der im Rotor 22 gespeicherten Ladung, und zwar geht dieser Überschlag vom magnetischen Rückschluss 24 durch das Hallfenster 48' zu den elektrischen Anschlüssen 49 des Sensors 48, was gewöhnlich eine Zerstörung des Sensors 48 bewirkt, wodurch der Motor 21 ebenfalls funktionsunfähig wird.

Bevorzugt wird das Hallfenster 48' radial etwas nach innen versetzt, was in Fig. 5 durch einen Pfeil 62 angedeutet ist, so dass es sich unterhalb der Stirnseite 27 des Rotormagneten 28 befindet. Dadurch wird der Luftabstand zum Rückschlussteil 24 vergrößert. Außerdem ist der Schlitz 43 vorgesehen, der es ermöglicht, dass die Ladung vom Rückschlussteil 24 durch diesen Schlitz 43 zu den mit Masse verbundenen Abschnitten 95', 95" auf der Leiterplatte 46 abfließt, wie das Fig. 6 zeigt. Dieser Schlitz 43 ist gegenüber mechanischen Toleranzen unempfindlich und bietet bei separater Verbindung mit Masse eine gute ESD-Entladung, ohne durch eine etwaige Entladung Schaden zu nehmen. Man könnte also diesen Schlitz metaphorisch als Blitzableiter des Motors bezeichnen, und deshalb ist in Fig. 5 dort ein Blitzsymbol 60 eingezeichnet, wo die Entladung etwa stattfindet. Auf diese einfache Weise ist es möglich, einen solchen ECM ohne wesentliche Mehrkosten hochspannungsfest zu machen.

Fig. 6 zeigt nochmals eine schematische Darstellung der Leiterplatte 46. Für die elektrostatischen Spannungen, mit denen sich das magnetische Rückschlussteil (yoke) 24 im Betrieb aufladen kann, wirkt die Leiterplatte 46 als Isolator. Deshalb ist in der Leiterplatte 46 die Öffnung 43 vorgesehen, welche eine Luftstrecke darstellt, an deren unterem Ende sich die Abschnitte 95', 95" befinden, die mit Masse 112 direkt verbunden sind.

Wenn sich das Rückschlussteil 24 genügend aufgeladen hat, findet ein Überschlag 110 vom Rückschlussteil 24 zu einem der Abschnitte 95', 95" statt, da dies die kürzeste und widerstandsärmste Verbindung vom Rückschlussteil 24 nach Masse 112 darstellt. Dadurch wird der Sensor 48 gegen Zerstörung geschützt. Die Öffnung 43, in Verbindung mit den Abschnitten 95', 95", wirkt also im Prinzip wie ein "Blitzableiter" und schützt den Sensor 48 vor einer Zerstörung durch Überschläge.

Abwandlungen und Modifikationen sind im Rahmen des durch die Ansprüche definierten Schutzbereiches möglich.

## Patentansprüche

1. Elektronisch kommutierter Außenläufermotor (21), welcher aufweist:
Einen Innenstator (50);
einen mit einem Permanentmagneten (28) versehenen Außenrotor (22), welcher durch einen Luftspalt vom Innenstator (50) getrennt ist und zur Lagerung an diesem eine Welle (34) aufweist, an der ein Rückschlusselement (24) aus magnetisch leitendem Werkstoff befestigt ist, an welchem der Permanentmagnet (28) angeordnet ist,
und welcher eine am Innenstator (50) vorgesehene Leiterplatte (46) aufweist,
**gekennzeichnet durch** eine gedruckte Schaltung (46', 48), welche auf der vom Außenrotor (22) abgewandten Seite (47) der Leiterplatte (46) vorgesehen ist,
**durch** eine in der Leiterplatte (46) in einem Streuflussbereich des Permanentmagneten (28) vorgesehene erste Durchbrechung (48'), in der ein galvanomagnetischer Sensor (48) angeordnet ist, der im Betrieb, abhängig von der Drehstellung des Rotors (22) relativ zum Stator (50), Rotorstellungssignale erzeugt,
und **durch** eine zweite in der Leiterplatte (46) vorgesehene Durchbrechung (43), an deren Rand mindestens ein mit Masse (112) verbundener elektrischer Leiter (95', 95") vorgesehen ist, zu dem sich eine Ladung entladen kann, die sich im Betrieb im Motor (21) aufbaut.

2. Motor nach Anspruch 1, bei welchem der mit Masse (112) verbundene elektrische Leiter (95', 95") so angeordnet ist, dass sich zu ihm eine Ladung entladen kann, die sich im Betrieb im Rückschlusselement (24) aufbaut.

3. Motor nach Anspruch 1 oder 2, bei welchem ein auf der Leiterplatte (46) vorgesehener Masseanschluss (300) zumindest teilweise einen mit Masse verbundenen elektrischen Leiter (95', 95") bildet.

4. Motor nach einem der Ansprüche 1 bis 3, bei welchem mindestens ein mit einem niedrigen Potential verbundener elektrischer Leiter (95', 95") als metallisch Beschichtung mindestens auf der vom Außenrotor (22) abgewandten Seite (47) der Leiterplatte (46) ausgebildet ist.

5. Motor nach einem der vorhergehenden Ansprüche, bei welchem die zweite Durchbrechung (43) zumindest teilweise in einem Streuflussbereich des Permanentmagneten (28) angeordnet ist.

6. Motor nach einem der Ansprüche 1 bis 5, bei welchem die zweite Durchbrechung (43) sich von einem Außenrand der Leiterplatte (46) nach innen hin erstreckt.

7. Leiterplatte (46) für einen elektronisch kommutierten Außenläufermotor (21), welche aufweist:
eine Seite (47) mit einer gedruckten Schaltung, zum Anschluss elektronischer Bauelemente (46');
eine erste Durchbrechung (48') zur Aufnahme eines galvanomagnetischen Sensors (48); **gekennzeichnet durch** eine zweite Durchbrechung (43), an deren Rand mindestens ein mit Masse (112) verbundener elektrischer Leiter (95', 95", 97', 97") zur Ableitung einer ESD-Entladung (60) vorgesehen ist.

8. Leiterplatte nach Anspruch 7, bei welcher ein in der Leiterplatte (46) vorgesehener Masseanschluss (300) zumindest teilweise einen mit Masse (112) verbundenen elektrischen Leiter (95', 95", 97', 97") bildet.

9. Leiterplatte nach Anspruch 7 oder 8, bei welchem der mindestens eine mit Masse (112) verbundene elektrische Leiter (95', 95", 97', 97") als metallische Beschichtung (95', 95") der Leiterplatte (46) auf deren mit der gedruckten Schaltung versehenen Seite (47) ausgebildet ist.

10. Leiterplatte nach Anspruch 9, bei welcher die metallische Beschichtung (95', 95") mit Masse verbunden ist.

11. Leiterplatte nach einem der Ansprüche 7 bis 10, bei welcher sich die zweite Durchbrechung (43) in Richtung von einem Außenbereich der Leiterplatte (46) weg und zu dieser Leiterplatte (46) erstreckt.

## Claims

1. Electronically commutated external rotor motor (21) which comprises:
An internal stator (50);
an external rotor (22) which is provided with a permanent magnet (28), is separated by an air gap from the internal stator (50) and, in order to be mounted on the latter, comprises a shaft (34) to which a return element (24) of magnetically conductive material is fastened, on which return element the permanent magnet (28) is disposed,
and which motor comprises a printed circuit board (46) provided on the internal stator (50),
**characterised by** a printed circuit (46', 48) which is provided on the side (47) of the printed circuit board (46) which is remote from the external rotor (22),
by a first opening (48') which is provided in the printed circuit board (46) in a leakage flux region of the permanent magnet (28) and in which a galvanomagnetic sensor (48) is disposed, which sensor, dependent upon the rotary position of the rotor (22) relative to the stator (50), generates rotor position signals during operation,
and by a second opening (43) which is provided in the printed circuit board (46) and at the edge of which at least one electrical conductor (95', 95") connected to earth (112) is provided, to which conductor a charge building up in the motor (21) during operation can discharge.

2. Motor according to Claim 1, in which the electrical conductor (95', 95") connected to earth (112) is disposed so that a charge building up in the return element (24) during operation can discharge to this conductor.

3. Motor according to Claim 1 or 2, in which an earth connection (300) provided on the printed circuit board (46) forms at least in part an electrical conductor (95', 95") connected to earth.

4. Motor according to any one of Claims 1 to 3, in which at least one electrical conductor (95', 95") connected to a low potential is formed as a metallic coating at least on the side (47) of the printed circuit board (46) which is remote from the external rotor (22).

5. Motor according to any one of the preceding Claims, in which the second opening (43) is disposed at least in part in a leakage flux region of the permanent magnet (28).

6. Motor according to any one of Claims 1 to 5, in which the second opening (43) extends inwards from an external edge of the printed circuit board (46).

7. Printed circuit board (46) for an electronically commutated external rotor motor (21), which board comprises:
a side (47) with a printed circuit for the connection of electronic components (46);
a first aperture (48') for accommodating a galvanomagnetic sensor (48);
**characterised by**
a second aperture (43), at the edge of which at least one electrical conductor (95', 95" 97', 97") connected to earth (112) is provided in order to dissipate an electrostatic discharge.

8. Printed circuit board according to Claim 7, in which an earth connection (300) provided in the printed circuit board (46) forms at least in part an electrical conductor (95', 95", 97', 97") connected to earth (112).

9. Printed circuit board according to Claim 7 or 8, in which the at least one electrical conductor (95', 95", 97', 97") connected to earth (112) is formed as a metallic coating (95', 95") of the printed circuit board (46) on the side (47) thereof which is provided with the printed circuit.

10. Printed circuit board according to Claim 9, in which the metallic coating (95', 95") is connected to earth.

11. Printed circuit board according to any one of Claims 7 to 10, in which the second opening (43) extends in the direction away from an external region of the printed circuit board (46) and to this printed circuit board (46).

## Revendications

1. Moteur à rotor extérieur à commutation électronique (21), lequel présente :
un stator intérieur (50) ;
un rotor extérieur (22) pourvu d'un aimant permanent (28), lequel est séparé du stator intérieur (50) par un entrefer et présente pour son montage sur celui-ci un arbre (34) auquel est fixé un élément de retour magnétique (24) en matériau magnétiquement conducteur, sur lequel l'aimant permanent (28) est disposé,
et lequel présente une carte de circuit imprimé (46) prévue sur le stator intérieur (50),
**caractérisé par** un circuit imprimé (46', 48), lequel est prévu du côté (47) de la carte de circuit imprimé (46) opposé au rotor extérieur (22),
par une première ouverture (48') prévue dans la carte de circuit imprimé (46) dans une zone de flux de dispersion de l'aimant permanent (28), dans laquelle est disposé un capteur galvanomagnétique (48) qui, en fonctionnement, génère des signaux de position du rotor en fonction de la position de rotation du rotor (22) par rapport au stator (50),
et par une deuxième ouverture (43) prévue dans la carte de circuit imprimé (46), au bord de laquelle est prévu au moins un conducteur électrique (95', 95") relié à la masse (112), vers lequel peut se décharger une charge qui se crée dans le moteur (21) en fonctionnement.

2. Moteur selon la revendication 1, dans lequel le conducteur électrique (95', 95") relié à la masse (112) est disposé de façon qu'une charge qui se crée dans l'élément de retour magnétique (24) en fonctionnement puisse se décharger vers lui.

3. Moteur selon la revendication 1 ou 2, dans lequel une connexion de masse (300) prévue sur la carte de circuit imprimé (46) forme au moins partiellement un conducteur électrique (95', 95") relié à la masse.

4. Moteur selon l'une des revendications 1 à 3, dans lequel au moins un conducteur électrique (95', 95") relié à un potentiel bas est réalisé sous la forme d'un revêtement métallique au moins du côté (47) de la carte de circuit imprimé (46) opposé au rotor extérieur (22).

5. Moteur selon l'une des revendications précédentes, dans lequel la deuxième ouverture (43) est disposée au moins partiellement dans une zone de flux de dispersion de l'aimant permanent (28).

6. Moteur selon l'une des revendications 1 à 5, dans lequel la deuxième ouverture (43) s'étend depuis un bord extérieur de la carte de circuit imprimé (46) vers l'intérieur.

7. Carte de circuit imprimé (46) pour un moteur à rotor extérieur à commutation électronique (21), laquelle présente :
un côté (47) avec un circuit imprimé pour la connexion de composants électroniques (46') ;
une première ouverture (48') destinée à recevoir un capteur galvanomagnétique (48),
**caractérisée par** une deuxième ouverture (43) au bord de laquelle est prévu au moins un conducteur électrique (95', 95", 97', 97") relié à la masse (112) pour évacuer une décharge d'électricité statique (60).

8. Carte de circuit imprimé selon la revendication 7, dans laquelle une connexion de masse (300) prévue dans la carte de circuit imprimé (46) forme au moins partiellement un conducteur électrique (95', 95", 97', 97") relié à la masse (112).

9. Carte de circuit imprimé selon la revendication 7 ou 8, dans laquelle ledit au moins un conducteur électrique (95', 95", 97', 97") relié à la masse (112) est réalisé sous la forme d'un revêtement métallique (95', 95") de la carte de circuit imprimé (46) de son côté (47) pourvu du circuit imprimé.

10. Carte de circuit imprimé selon la revendication 9, dans laquelle le revêtement métallique (95', 95") est relié à la masse.

11. Carte de circuit imprimé selon l'une des revendications 7 à 10, dans laquelle la deuxième ouverture (43) s'étend dans une direction qui l'éloigne d'une zone extérieure de la carte de circuit imprimé (46) et vers cette carte de circuit imprimé (46).
